# FASCICULE DE BREVET EUROPEEN

(11) **EP 4 262 082 B1**
(45) Date de publication et mention de la délivrance du brevet: **27.11.2024**
(21) Numéro de dépôt: 23166356.8
(22) Date de dépôt: 03.04.2023
(51) Int. Cl.: H02S 40/00

(54) **SYSTÈME DE TRAITEMENT D'UN MODULE PHOTOVOLTAÏQUE POUR AUGMENTER SON RENDEMENT**
VERARBEITUNGSSYSTEM FÜR EIN PHOTOVOLTAIKMODUL ZUR ERHÖHUNG DER EFFIZIENZ
SYSTEM FOR PROCESSING A PHOTOVOLTAIC MODULE TO INCREASE THE EFFICIENCY THEREOF

(30) Priorité: 15.04.2022 FR 2203531
(43) Date de publication de la demande: 18.10.2023
(73) Titulaire: Commissariat à l'Energie Atomique et aux Energies Alternatives, 75015 Paris (FR)
(72) Inventeur: JERONIMO, Pedro, 38054 GRENOBLE cedex 09 (FR); CARON, Jean-Sébastien, 38054 GRENOBLE cedex 09 (FR); VEIRMAN, Jordi, 38054 GRENOBLE cedex 09 (FR)
(74) Mandataire: INNOV-GROUP

(56) Documents cités:
- WO-A1-2016/156592
- KR-B1- 101 462 107
- US-A1- 2014 109 949
- US-A1- 2015 270 431

## Description

### Domaine technique de l'invention

La présente invention se rapporte à un système de traitement d'au moins un module photovoltaïque pour augmenter son rendement.

### Etat de la technique

Les cellules photovoltaïques à hétérojonction de silicium (SHJ) sont connues pour voir leur rendement de conversion énergétique s'améliorer d'environ 0,3 % absolu sous l'action conjuguée de l'éclairement et de la température. Ainsi, il est à présent courant de procéder à un traitement dit de bonification (appelé "light soaking") des empilements notamment destinés à former les cellules photovoltaïques SHJ, afin d'en augmenter leur rendement de conversion.

Le document WO2013/001440 décrit un exemple de procédé de traitement de cellules photovoltaïques de type SHJ comprenant un substrat en silicium cristallin dopé n. Dans ce procédé de traitement, la cellule photovoltaïque est soumise à un flux lumineux d'irradiance supérieure ou égal à 500 W/m2 pendant une durée d'environ 10 heures, tout en étant chauffée à une température comprise entre 20 °C et 200 °C.

La demande de brevet FR3099294A1 décrit un procédé de traitement d'un empilement dit précurseur de cellule photovoltaïque à hétérojonction. Ce procédé est mis en oeuvre en fin de fabrication et consiste principalement à exposer ledit empilement à un rayonnement électromagnétique intense (supérieur à 200kW/m²) pendant une durée relativement courte (une dizaine de secondes). Grâce à cette exposition temporaire et intense au rayonnement, on a constaté une bonification de la cellule et une augmentation de son rendement en fonctionnement.

Le document US 2014/109949 A1 décrit un système de traitement pour module photovoltaïque afin de recouvrer les performances du module, comprenant une source d'émission et des moyens pour déplacer le module par rapport à la source de façon à balayer toute la surface du module.

Cependant, le rendement d'un module une fois installé dans un champ photovoltaïque aura tendance à baisser avec le temps et il n'existe aucune solution pertinente pour accroitre à nouveau ce rendement après quelques mois/années d'utilisation.

De plus certains modules déjà installés peuvent ne jamais avoir subi un seul traitement de bonification de ses cellules. Il est donc pertinent de pouvoir proposer une solution pour traiter ces modules, a posteriori.

Le but de l'invention est donc de proposer un système permettant d'améliorer le rendement d'un module photovoltaïque, même après quelques mois/années d'utilisation ou lorsqu'il n'a jamais subi aucun traitement de bonification.

### Exposé de l'invention

Ce but est atteint par un système de traitement d'une surface à traiter d'une installation photovoltaïque, formée d'un module photovoltaïque ou de plusieurs modules photovoltaïques juxtaposés, ledit système comprenant une source d'émission de rayonnements électromagnétiques, configurée pour émettre des rayonnements électromagnétiques, ledit système comportant :
- Des moyens de mise en mouvement de ladite source d'émission,
- Une unité de contrôle, configurée pour contrôler ladite source d'émission en vue d'émettre lesdits rayonnements électromagnétiques pendant une durée d'exposition déterminée, à une irradiance donnée à destination d'au moins une partie de la surface à traiter,
- L'unité de contrôle étant configurée pour contrôler les moyens de mise en mouvement pour déplacer ladite source d'émission en vis-à-vis de ladite surface à traiter jusqu'à balayer toute la surface photovoltaïque.

Selon une particularité, le système comporte des moyens de détermination d'un degré d'opacité de l'installation photovoltaïque au niveau de ladite au moins une partie de la surface à traiter.

Selon une autre particularité, les moyens de détermination de l'opacité comportent :
- Des moyens d'émission d'un faisceau lumineux à destination de ladite au moins une partie de la surface à traiter et des moyens de réception d'un flux lumineux réfléchi par ladite au moins une partie de la surface à traiter,
- Un module de calcul du degré d'opacité, exécuté par ladite unité de contrôle, à partir de données reçues en provenance des moyens de réception.

Selon une autre particularité, le système comporte des moyens de refroidissement du module et de régulation de la température du module à une valeur déterminée lors de l'exposition de ladite au moins une partie de la surface à traiter auxdits rayonnements électromagnétiques.

Selon une autre particularité, le système comporte des moyens de détermination des dimensions de la surface à traiter de l'installation photovoltaïque.

Selon une réalisation particulière, l'unité de contrôle est configurée pour exécuter une séquence de traitement de ladite surface à traiter, comprenant lesdites étapes suivantes :
a) Détermination du degré d'opacité de l'installation photovoltaïque au niveau d'une première partie de la surface à traiter ;
b) Détermination de l'irradiance et de la durée d'exposition à appliquer à ladite première partie de la surface à traiter en tenant compte du degré d'opacité déterminé ;
c) Contrôle de la source d'émission pour irradier ladite première partie de la surface ;
d) Contrôle des moyens de mise en mouvement de la source d'émission pour la placer en vis-à-vis d'une deuxième partie de la surface à traiter, distincte de la première partie ;
e) Exécution des étapes a) à d) appliquées à la deuxième partie de la surface à traiter.

Selon une autre réalisation particulière, l'unité de contrôle est configurée pour exécuter une séquence de traitement de ladite surface à traiter, comprenant lesdites étapes suivantes :
a) Balayage de la surface du module photovoltaïque par déplacement de source d'émission à une vitesse de consigne ;
b) Détermination du degré d'opacité du module au niveau de chaque partie de la surface à traiter ;
c) Détermination de l'irradiance et de la durée d'exposition à appliquer à chaque partie de la surface à traiter en tenant compte du degré d'opacité déterminé ;
d) Contrôle de la source d'émission pour irradier chaque partie de la surface à traiter ;
e) Tant que le degré d'opacité déterminé est constant, maintien de la vitesse de déplacement de la source d'émission à la vitesse de consigne ;
f) Lorsque la variation du degré d'opacité dépasse une valeur seuil, détermination d'une nouvelle irradiance et d'une nouvelle durée d'exposition à appliquer, et détermination d'une nouvelle vitesse de consigne à appliquer à la source d'émission ;

Selon une particularité, les moyens de mise en mouvement comportent au moins un rail fixé sur un bord de l'installation photovoltaïque et en ce que le système comporte un bras supportant ladite source d'émission adapté pour coulisser le long dudit rail.

Selon une autre particularité, le système comporte des moyens de nettoyage de la surface à traiter.

Selon une autre particularité, l'irradiance est choisie comprise entre 1 et 100kW/m2. Selon une autre particularité, l'irradiance est choisie comprise entre 1kW/m2 et 10 kW/m 2.

Selon une autre particularité, la durée d'exposition est comprise entre 1 seconde et 30 minutes.

Selon une autre particularité, la température de l'installation photovoltaïque est régulée à une valeur comprise entre 100°C et 250°C.

### Brève description des figures

D'autres caractéristiques et avantages vont apparaître dans la description détaillée qui suit faite en regard des dessins annexés dans lesquels :
- La figure 1 représente, vue en perspective et de manière schématique, la structure d'un module photovoltaïque ;
- La figure 2 représente, vue de côté, la structure d'un module photovoltaïque ;
- La figure 3 illustre le principe de fonctionnement de l'invention ;
- La figure 4 représente de manière schématique l'architecture fonctionnelle du système de l'invention ;
- La figure 5 montre un exemple de réalisation de la face interne du système de l'invention ;
- Les figures 6A et 6B montrent un exemple de réalisation de la solution de détermination du degré d'opacité d'un module photovoltaïque ;
- La figure 7 montre un exemple d'algorithme de détermination du degré d'opacité d'un module photovoltaïque ;
- Les figures 8A et 8B montrent deux exemples de réalisation du système de l'invention ;
- Les figures 9A et 9B montrent deux exemples d'algorithme de fonctionnement du système de l'invention ;

### Description détaillée d'au moins un mode de réalisation

L'invention consiste à venir éclairer artificiellement un module photovoltaïque M déjà installé dans un champ photovoltaïque, afin de le bonifier et d'améliorer son rendement actuel.

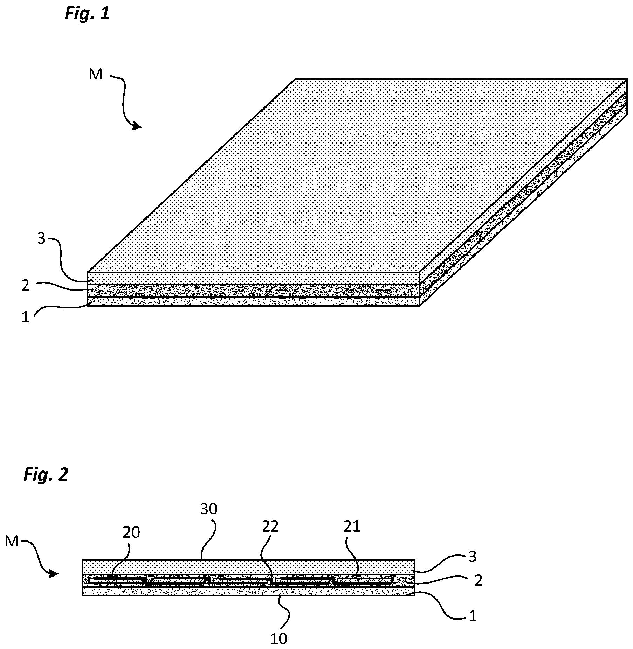

En référence à la figure 1 et à la figure 2, de manière connue, un module photovoltaïque M comporte plusieurs couches superposées et assemblées entre elles :
- Une première couche 1 (appelée couramment "backsheet") formant un premier élément de protection en face arrière 10 ; cette première couche 1 est habituellement réalisée dans un matériau de type polymère ;
- Une deuxième couche 2, dite couche intermédiaire, intercalée entre la première couche 1 et la troisième couche 3 (décrite ci-dessous), permettant l'assemblage d'un côté de la première couche et de l'autre côté de la troisième couche ; cette couche intermédiaire 2 comporte les cellules photovoltaïques 20, la connectique électrique 22 et une enveloppe d'encapsulation 21 arrangée autour des cellules photovoltaïques ;
- Une troisième couche 3 formant un deuxième élément de protection en face avant 30 ; cette troisième couche 3 est habituellement en verre mais elle peut éventuellement être formée d'un polymère transparent ; La troisième couche forme la surface externe plane du module, destinée à être exposée à un rayonnement.

Pour des soucis de lisibilité sur les figures annexées, les différentes couches du module ne sont pas représentées à l'échelle. A titre d'exemple, la première couche 1 peut présenter une épaisseur de quelques centaines de µm (par exemple environ 350 µm), la deuxième couche 2 peut présenter une épaisseur pouvant aller jusqu'à 1 mm et la troisième couche 3 peut présenter une épaisseur d'environ 3 à 4 mm.

La première couche 1 peut notamment assurer une fonction d'imperméabilité aux gaz et à l'eau, une fonction de protection/isolation électrique et une fonction de protection mécanique. Cette première couche 1 peut être réalisée à base d'un polymère fluoré. Il peut s'agir du polyfluorure de vinyle (PVF), par exemple commercialisé sous le nom TEDLAR (marque déposée par la société DuPont (marque déposée)).

De manière non limitative, la première couche 1 peut elle-même être composée d'un empilement de plusieurs strates : une strate de PVF, une strate en PET (poly(téréphtalate) d'éthylène), une strate de PVF.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la première couche 1 d'un côté et la troisième couche 3 de l'autre côté et permettre l'assemblage des trois couches entre elles. Les trois couches peuvent être assemblées entre elles par laminage à chaud, de sorte que la première couche et la troisième couche viennent adhérer au matériau de l'enveloppe d'encapsulation, formant ainsi un empilement monobloc.

Dans la couche intermédiaire 2, les cellules photovoltaïques 20 sont connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M.

Le champ photovoltaïque comporte en règle générale plusieurs modules photovoltaïques alignés et juxtaposés, avantageusement tous identiques.

Dans la suite de la description, le système de l'invention est décrit pour être utilisé sur un module photovoltaïque. Il faut comprendre qu'il peut être utilisé successivement sur l'ensemble des modules photovoltaïques du champ photovoltaïque.

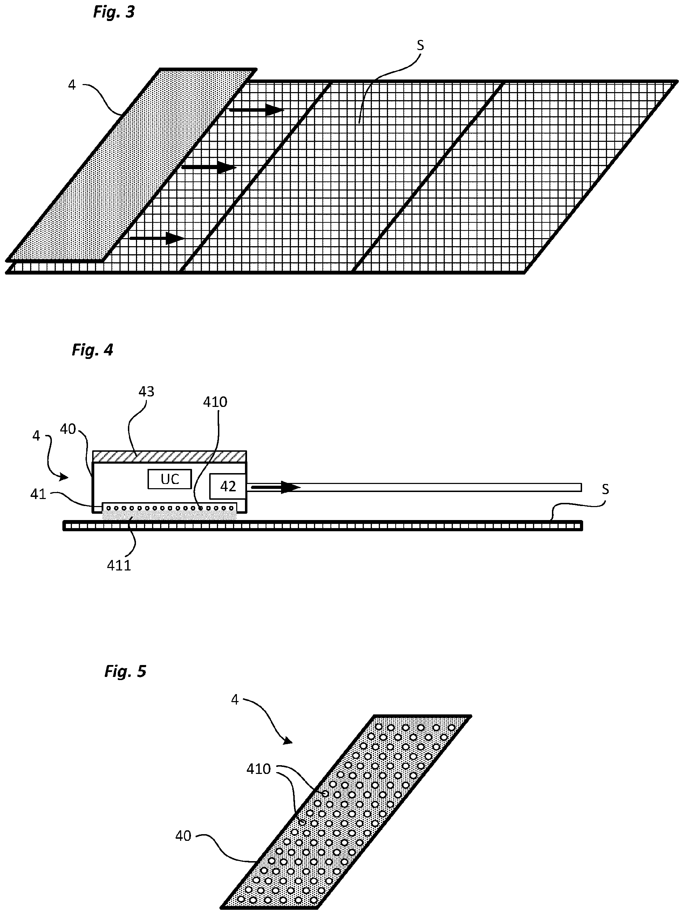

Dans la suite de la description, et comme illustré par la figure 3, on fait référence à la surface S à traiter par le système 4, qui peut correspondre à la surface d'un module photovoltaïque ou à celle formée par la juxtaposition de plusieurs modules photovoltaïques. Comme indiqué ci-dessus, la surface S peut être formée d'une paroi en verre ou d'un matériau polymère transparent, placée au-dessus des cellules photovoltaïques 20 à bonifier.

En référence à la figure 4, le système 4 de l'invention comporte un corps 40 destiné à venir se positionner en vis-à-vis de la surface à traiter.

Le système comporte une unité de contrôle UC comprenant des moyens de calcul et de commande. Il peut s'agir par exemple d'un automate programmable comprenant plusieurs modules d'entrées/sorties.

Le système de l'invention comporte une source d'émission 41 de rayonnements électromagnétiques. Cette source d'émission 41 est avantageusement composée de plusieurs diodes électroluminescentes 410 intégrées audit corps du système. Comme représenté sur la figure 5, elle peut comporter plusieurs rangées de diodes électroluminescentes intégrées dans un support du corps 40 du système.

La source d'émission 41 forme une zone d'éclairement 411 définie par la surface totale que la source 41 est capable de traiter lorsqu'elle est active. Cette zone d'éclairement 411 correspond par exemple au moins à toute la zone délimitée par les diodes électroluminescentes qui forment la source d'émission 41.

Lorsque le corps 40 du système 4 est positionné en vis-à-vis de la surface S à traiter, les diodes électroluminescentes 410 de la source 41 sont positionnées de manière à pouvoir exposer la surface S à un rayonnement suffisant pour obtenir l'effet de bonification. De manière non limitative, plusieurs diodes électroluminescentes 410 sont positionnées de manière à émettre suivant une direction principale qui est normale à la surface S à traiter.

Le rayonnement est appliqué pendant une durée de traitement (appelée durée d'exposition T) déterminée, pouvant varier en fonction de l'irradiance E et de la longueur d'onde du rayonnement émis. Pour rappel, l'irradiance E, appelée aussi éclairement énergétique ou densité surfacique de puissance lumineuse, représente la puissance du rayonnement électromagnétique reçu par unité de surface, cette unité de surface étant orientée perpendiculairement à la direction du rayonnement électromagnétique émis. Le rayonnement électromagnétique peut être monochromatique (une seule longueur d'onde) ou polychromatique (plusieurs composantes de longueurs d'ondes différentes). De manière plus précise, le rayonnement peut être émis à au moins une longueur d'onde comprise entre 400nm et 1100nm, préférentiellement à une longueur d'onde comprise entre 800nm et 1000nm.

De manière non limitative, selon les cas de fonctionnement, le rayonnement électromagnétique peut être émis à une irradiance comprise entre 1kW/m2 à 100kW/m2 et pendant une durée comprise entre 5 secondes à 30 minutes.

A titre d'exemple, le rayonnement électromagnétique peut être émis à une irradiance E supérieure ou égale à 8kW/m2 et pendant une durée inférieure ou égale à 4 minutes.

Le rayonnement électromagnétique peut également être émis à une irradiance E supérieure ou égale à 50kW/m2 et pendant une durée inférieure ou égale à 15 secondes.

Pendant l'émission du rayonnement, la température du module M est avantageusement maintenue à une valeur la plus stable possible, par exemple choisie entre 100°C et 250°C. Il faut noter qu'il est important que le traitement apporté au module ne conduise pas à excéder la valeur minimale des températures maximales théoriquement admissibles pour les soudures présentes dans le module et pour le matériau d'encapsulation, au risque d'endommager le module.

Le système peut être doté de moyens de gestion de la température au niveau de la surface à traiter :
- Un ou plusieurs capteurs de température agencés pour mesurer la température sur la surface S traitée ;
- Des moyens de refroidissement 43 contrôlés pour réguler la température en surface ; ces moyens de refroidissement peuvent comporter un ou plusieurs ventilateurs et/ou solution de refroidissement par fluide caloporteur ; ces moyens de refroidissement 43 sont avantageusement intégrés au corps 40 du système 4 de l'invention ;
- Un bloc logiciel de régulation de la température, exécuté par l'unité de contrôle UC, chargé de générer les commandes à envoyer aux moyens de refroidissement pour réguler la température à la valeur souhaitée ;

Le système de l'invention est destiné à traiter la surface de chaque module photovoltaïque du champ photovoltaïque.

Il faut noter que si la surface S à traiter est inférieure à la taille de la zone d'éclairement proposée par le système, le système 4 pourra traiter toute la surface S en une seule fois. Dans cette situation, l'activation de la source d'émission 41 peut être partielle et adaptée à la surface S à traiter.

Si la surface S à traiter est supérieure à la taille de la zone d'éclairement 411 proposée par le système 4, le système 4 sera amené à se déplacer en vis-à-vis de la surface S pour traiter toutes les zones de la surface prises chacune l'une après l'autre, jusqu'à couvrir toute la surface.

Le système 4 comporte avantageusement des moyens de détermination de la surface de chaque module et de la surface S totale à traiter et des moyens de comparaison avec sa zone d'éclairement 411. L'unité de contrôle UC détermine ainsi son mode opératoire pour traiter l'ensemble de la surface S.

Le système 4 comporte ainsi des moyens 42 de mise en mouvement du système 4 pour déplacer la source d'émission 41 et sa zone d'éclairement 411 en vis-à-vis de chaque zone de la surface S à traiter.

Le système 4 comporte avantageusement des moyens de détermination du degré d'opacité DO (exprimé en % - à 0% la surface du module est opaque et à 1 00% la surface du module est transparente) de chaque module photovoltaïque. Les modules photovoltaïques M étant situés à l'extérieur, ils sont exposés aux particules, tels que poussières, sable, terre, augmentant leur degré d'opacité par rapport à celui obtenu en sortie d'usine.

Les moyens de détermination du degré d'opacité DO comportent par exemple une unité émettrice de signaux lumineux, par exemple de type infrarouge, à destination d'au moins une zone de la surface du module photovoltaïque et une unité réceptrice des signaux réfléchis par la surface du module photovoltaïque. Ces moyens de détermination sont avantageusement intégrés au système de l'invention. L'unité émettrice et l'unité réceptrice peuvent être intégrés au niveau de la source d'émission 41 du système.

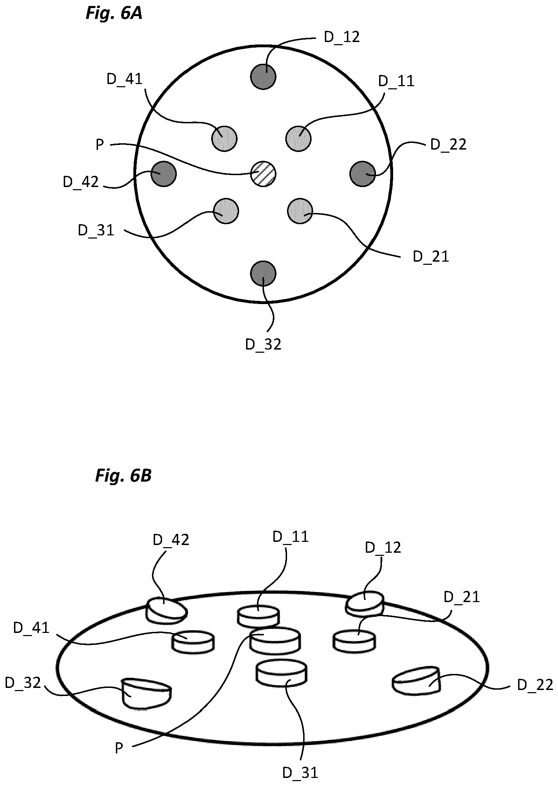

L'unité réceptrice envoie ensuite des données à l'unité de contrôle UC qui exécute un bloc de détermination du degré d'opacité du module photovoltaïque au niveau de la zone qui a été scannée. A titre d'exemple, en référence à la figure 6A et à la figure 6B, l'unité émettrice peut comporter plusieurs diodes électroluminescentes, par exemple au nombre de huit, disposées de manière symétrique autour d'un phototransistor P formant l'unité réceptrice. Un premier jeu de quatre diodes électroluminescentes D_11, D_21, D_31, D_41 disposées en carré peut être placé autour du phototransistor P, orientées pour émettre suivant une direction normale à la surface du panneau et un deuxième jeu de quatre diodes électroluminescentes D_12, D_22, D_32, D_42 peut être placé à l'extérieur du premier jeu, chacune orientée et inclinée pour émettre suivant une direction à 20° par rapport à la surface du module. Les deux jeux de diodes électroluminescentes forment ainsi deux cercles concentriques situées autour du phototransistor P. Bien entendu, d'autres arrangements pourraient être imaginés.

Ces unités peuvent être intégrées directement à la matrice de diodes électroluminescentes de la source d'émission 41. Elles seront activées alors que la source d'émission 41 est inactive.

En fonction du degré d'opacité DO (en %) déterminé, l'unité de contrôle UC peut ajuster l'irradiance E et la durée d'exposition T à appliquer à la zone traitée.

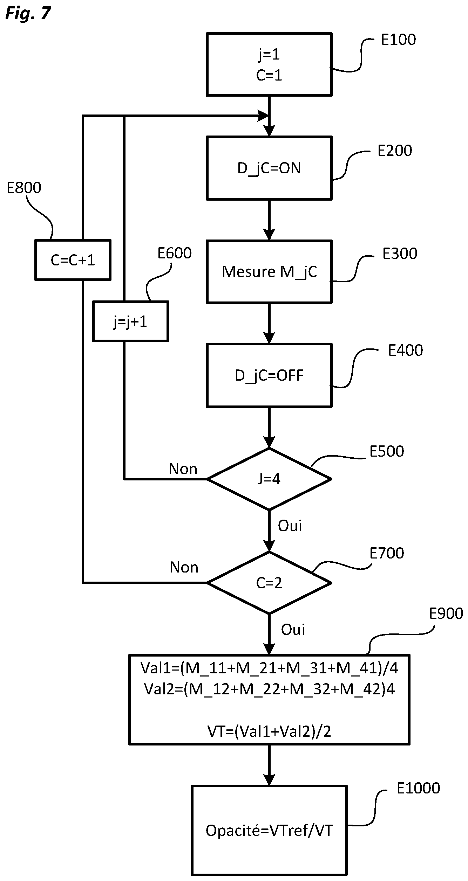

La figure 7 montre un exemple d'algorithme de détermination du degré d'opacité DO d'un module photovoltaïque, à partir de l'unité émettrice à huit diodes électroluminescentes décrites ci-dessus, et du phototransistor P, positionnés en face du module photovoltaïque à caractériser. Comme représentée sur les figures 6A et 6B, l'unité émettrice comporte par exemple deux cercles (référencés C - pouvant prendre la valeur 1 ou la valeur 2) et quatre diodes électroluminescentes par cercle (chaque diode électroluminescente a une référence j, avec j pouvant aller de 1 à 4 pour chaque cercle C).

Selon cet algorithme, les étapes sont les suivantes :
- Une première étape d'initialisation E100 avec j=1 et C=1 ;
- Une deuxième étape E200 dans laquelle la première diode électroluminescente (référencée D_jC) du premier cercle est allumée ;
- A la troisième étape E300, on fait une première mesure M_jC du flux lumineux reçu par le phototransistor P - chaque mesure est exprimée en pourcentage et correspond donc au rapport entre le signal émis et le signal reçu ;
- A la quatrième étape E400, la première diode électroluminescente du premier cercle est éteinte ;
- Ce principe de mesure est reproduit pour chaque autre diode électroluminescente du premier cercle, et tant que j n'est pas égal à 4 - étapes E500 et E600 ;
- Le même principe est reproduit ensuite pour le deuxième cercle (C=2) de diodes électroluminescentes - Etape E700 et E800 ;
- Lorsque l'on a obtenu toutes les mesures M_jC pour chaque diode électroluminescente des deux cercles, on détermine une valeur moyenne pour le premier cercle et une valeur moyenne pour le deuxième cercle, puis on détermine une moyenne VT à partir des deux valeurs moyennes - Etape E900 ;
- On détermine ensuite le degré d'opacité en appliquant la relation Opacité = VTref/VT, VTref correspondant à une valeur de référence préétablie, par exemple mesurée en usine sur un corps noir - Etape E1000 ;

En considérant que la surface S à traiter est supérieure à la zone d'éclairement 411 du système, deux solutions peuvent être mises en oeuvre.

Dans une première solution, l'unité de contrôle UC détermine le degré d'opacité DO d'une première zone de la surface S à traiter puis calcule l'irradiance E à appliquer à cette première zone et la durée d'exposition T en tenant compte de ce degré d'opacité DO. L'unité de contrôle UC commande ensuite la source d'émission 41 pour appliquer ces paramètres à cette première zone à traiter. Une fois cette première zone traitée, l'unité de contrôle UC commande les moyens 42 de mise en mouvement pour déplacer la source 41 vers une deuxième zone de la surface S à traiter et reproduit les mêmes étapes. Le système 4 fonctionne ainsi de manière discontinue, chaque zone de la surface S étant traitée l'une après l'autre et pour chaque zone, la détermination du degré d'opacité DO et l'éclairement appliqué étant mis en oeuvre successivement. La vitesse de déplacement du système 4 est nulle lors du traitement et devient non nulle lorsque le système est déplacé d'une première zone de la surface S à traiter vers une deuxième zone distincte de la première zone.

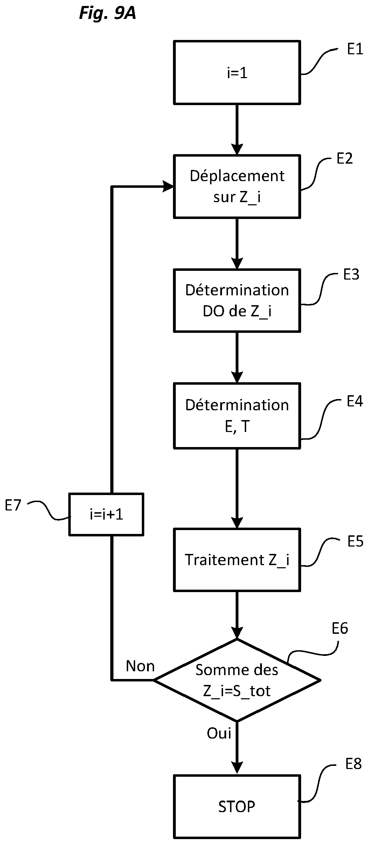

En référence à la figure 9A, le principe de fonctionnement en discontinu pourrait être le suivant :
- E1 : Le système 4 est initialisé pour une première zone de la surface (i=1) ;
- E2 : Le système est positionné au-dessus de la première zone Z_1 ;
- E3 : Pour cette première zone, l'unité de contrôle détermine le degré d'opacité DO ;
- E4 : En fonction du degré d'opacité DO déterminé, l'unité de contrôle détermine l'irradiance E à appliquer et la durée d'exposition T ;
- E5 : L'unité de contrôle commande le traitement de la zone Z_1 ;
- E6 + E7 : Tant que la somme des Z_i est inférieure à S_tot, le système se déplace vers une nouvelle zone à traiter, avec i=i+1 ; S_tot correspond à la surface totale à traiter ;
- E8 : Lorsque la somme des Z_i est égale à S_tot, le système s'arrête ;

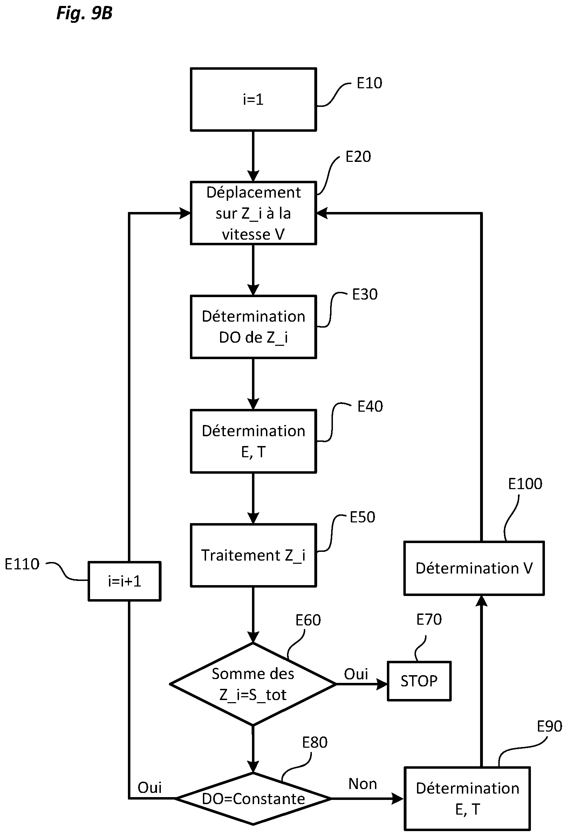

Dans une deuxième solution, le système 4 peut être amené à fonctionner de manière continue de sorte que l'unité de contrôle UC exécute une boucle de régulation dans laquelle elle détermine en permanence une vitesse de déplacement à appliquer à la source d'émission 41 pour que chaque zone de la surface S soit soumise à l'irradiance déterminée correspondant à son degré d'opacité DO. La vitesse de déplacement de la source d'émission 41 est ainsi mise à jour en temps réel et régulée en tenant compte du degré d'opacité DO de chaque zone de la surface qui est traitée et balayée par le système 4. A titre d'exemple, en référence avec la figure 9B, le principe de fonctionnement en continu pourrait être le suivant :
- E10 : Le système est initialisé pour une première zone de la surface (i=1) ;
- E20 : Le système se déplace sur la zone Z_1 à la vitesse V ;
- E30 : Pour cette première zone Z_1, l'unité de contrôle détermine le degré d'opacité DO ;
- E40 : En fonction du degré d'opacité déterminé, l'unité de contrôle détermine l'irradiance E à appliquer et la durée d'exposition T ;
- E50 : L'unité de contrôle traite la zone Z_1 ;
- E60 + E110 : Tant que la somme des Z_i est inférieure à S_tot, le système se déplace et la zone à traiter peut être modifiée, avec i=i+1 (voir ci-dessous) ; S_tot correspond à la surface totale à traiter ;
- E70 : Lorsque la somme des Z_i est égale à S_tot, le système s'arrête ;
- E80 : Tant que le degré d'opacité DO reste constant, le système se déplace vers une nouvelle zone à traiter à la vitesse V ;
- E90 : Lorsque le degré d'opacité DO mesurée change, l'unité de contrôle détermine une nouvelle irradiance E et une nouvelle durée d'exposition T ; La modification du degré d'opacité DO peut être décidée lorsque sa variation dépasse une valeur seuil ;
- E100 : L'unité de contrôle peut modifier la vitesse V du système pour tenir compte de ces modifications ; Pour tenir compte du changement d'opacité, il peut en effet modifier l'irradiance appliquée et/ou la durée d'exposition (en jouant sur la vitesse de déplacement du système) ;

Il faut noter que la source d'émission 41 reste toujours positionnée à une distance identique par rapport à la surface S à traiter. Cette dernière étant plane, la source d'émission 41 suit donc avantageusement un mouvement rectiligne suivant une direction parallèle à la surface à traiter.

Selon une réalisation particulière, les moyens 42 de mise en mouvement peuvent comporter des roues, venant par exemple se poser directement sur la surface S à traiter et un moteur électrique commandé pour entraîner lesdites roues.

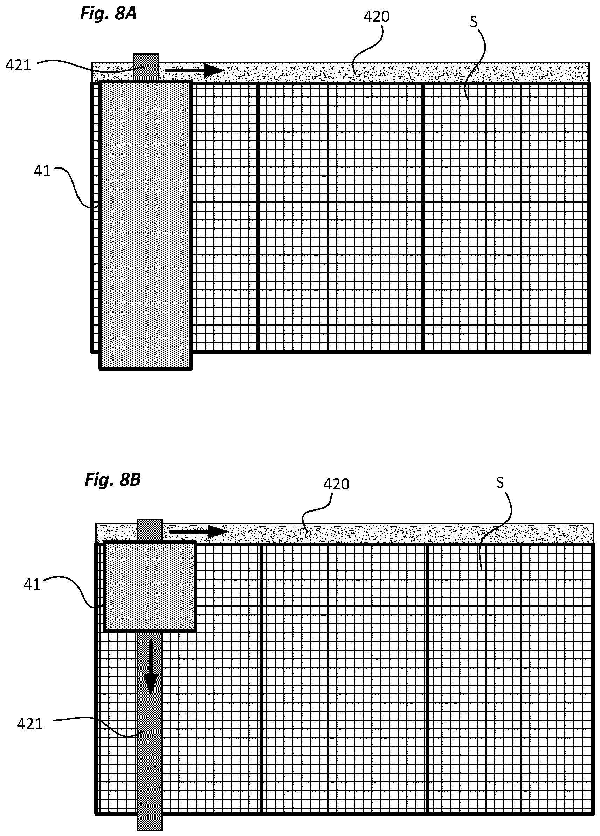

Selon une autre réalisation particulière illustrée par la figure 8A et la figure 8B, les moyens 42 de mise en mouvement peuvent comporter un rail 420 fixé sur un bord d'un module photovoltaïque ou de plusieurs modules photovoltaïques juxtaposés et le long duquel peut coulisser un bras 421 du système et portant ainsi la source d'émission 41. En référence à la figure 8B, le bras 421 peut lui-même former une glissière le long de laquelle la source d'émission 41 peut coulisser sous la forme d'un chariot. De cette manière, la source est apte à être déplacée suivant les deux axes (X et Y) parallèlement à la surface du panneau. Des moyens de déplacement en hauteur (suivant l'axe Z) pourrait également être prévus, en vue de régler la distance de la source d'émission 41 par rapport à la surface S à traiter.

Toute autre solution de montage du système pourrait être prévue.

Le système 4 peut être doté de divers perfectionnements, notamment :
- La présence de moyens de nettoyage, type brosse ou équivalents, solidaires du système en déplacement et chargés de nettoyer la surface S à traiter au fur et à mesure de son déplacement ;
- La présence de moyens de communication, commandés par l'unité de contrôle UC, permettant d'envoyer des données lors du fonctionnement du système, tels que température, vitesse de déplacement, position, irradiance...

## Revendications

1. Système (4) de traitement d'une surface (S) à traiter d'une installation photovoltaïque, formée d'un module photovoltaïque ou de plusieurs modules photovoltaïques juxtaposés, ledit système (4) comprenant une source d'émission (41) de rayonnements électromagnétiques, configurée pour émettre des rayonnements électromagnétiques, ledit système (4) étant **caractérisé en ce qu'**il comporte :
- Des moyens (42) de mise en mouvement de ladite source d'émission (41),
- Une unité de contrôle (UC), configurée pour contrôler ladite source d'émission (41) en vue d'émettre lesdits rayonnements électromagnétiques pendant une durée d'exposition (T) déterminée, à une irradiance (E) donnée à destination d'au moins une partie de la surface (S) à traiter,
- L'unité de contrôle (UC) étant configurée pour contrôler les moyens (42) de mise en mouvement pour déplacer ladite source d'émission en vis-à-vis de ladite surface à traiter jusqu'à balayer toute la surface photovoltaïque.

2. Système selon la revendication 1, **caractérisé en ce qu'**il comporte des moyens de détermination d'un degré d'opacité (DO) de l'installation photovoltaïque au niveau de ladite au moins une partie de la surface à traiter.

3. Système selon la revendication 2, **caractérisé en ce que** les moyens de détermination de l'opacité comportent :
- Des moyens d'émission d'un faisceau lumineux à destination de ladite au moins une partie de la surface à traiter et des moyens de réception d'un flux lumineux réfléchi par ladite au moins une partie de la surface à traiter,
- Un module de calcul du degré d'opacité, exécuté par ladite unité de contrôle (UC), à partir de données reçues en provenance des moyens de réception.

4. Système selon l'une des revendications 1 à 3, **caractérisé en ce qu'**il comporte des moyens de refroidissement (43) du module et de régulation de la température du module à une valeur déterminée lors de l'exposition de ladite au moins une partie de la surface (S) à traiter auxdits rayonnements électromagnétiques.

5. Système selon l'une des revendications 1 à 4, **caractérisé en ce qu'**il comporte des moyens de détermination des dimensions de la surface à traiter de l'installation photovoltaïque.

6. Système selon l'une des revendications 1 à 5, **caractérisé en ce que** l'unité de contrôle (UC) est configurée pour exécuter une séquence de traitement de ladite surface (S) à traiter, comprenant lesdites étapes suivantes :
a. Détermination du degré d'opacité (DO) de l'installation photovoltaïque au niveau d'une première partie de la surface à traiter ;
b. Détermination de l'irradiance et de la durée d'exposition à appliquer à ladite première partie de la surface à traiter en tenant compte du degré d'opacité déterminé ;
c. Contrôle de la source d'émission (41) pour irradier ladite première partie de la surface ;
d. Contrôle des moyens (42) de mise en mouvement de la source d'émission (41) pour la placer en vis-à-vis d'une deuxième partie de la surface à traiter, distincte de la première partie ;
e. Exécution des étapes a) à d) appliquées à la deuxième partie de la surface à traiter.

7. Système selon l'une des revendications 1 à 5, **caractérisé en ce que** l'unité de contrôle (UC) est configurée pour exécuter une séquence de traitement de ladite surface (S) à traiter, comprenant lesdites étapes suivantes :
a. Balayage de la surface du module photovoltaïque par déplacement de source d'émission (41) à une vitesse de consigne ;
b. Détermination du degré d'opacité (DO) du module au niveau de chaque partie de la surface à traiter ;
c. Détermination de l'irradiance et de la durée d'exposition à appliquer à chaque partie de la surface à traiter en tenant compte du degré d'opacité déterminé ;
d. Contrôle de la source d'émission (41) pour irradier chaque partie de la surface à traiter ;
e. Tant que le degré d'opacité déterminé est constant, maintien de la vitesse de déplacement de la source d'émission à la vitesse de consigne ;
f. Lorsque la variation du degré d'opacité dépasse une valeur seuil, détermination d'une nouvelle irradiance et d'une nouvelle durée d'exposition à appliquer, et détermination d'une nouvelle vitesse de consigne à appliquer à la source d'émission (41) ;

8. Système selon l'une des revendications 1 à 7, **caractérisé en ce que** les moyens de mise en mouvement comportent au moins un rail (420) fixé sur un bord de l'installation photovoltaïque et **en ce que** le système comporte un bras (421) supportant ladite source d'émission (41) adapté pour coulisser le long dudit rail.

9. Système selon l'une des revendications 1 à 8, **caractérisé en ce qu'**il comporte des moyens de nettoyage de la surface (S) à traiter.

10. Système selon l'une des revendications 1 à 9, **caractérisé en ce que** l'irradiance est choisie comprise entre 1 et 100kW/m2.

11. Système selon la revendication 10, **caractérisé en ce que** l'irradiance est choisie comprise entre 1kW/m2 et 10kW/m2.

12. Système selon l'une des revendications 1 à 11, **caractérisé en ce que** la durée d'exposition est comprise entre 1s et 30 minutes.

13. Système selon l'une des revendications 1 à 12, **caractérisé en ce que** la température de l'installation est régulée à une valeur comprise entre 100°C et 250°C.

## Patentansprüche

1. System (4) zur Behandlung einer zu behandelnden Oberfläche (S) einer Photovoltaikanlage, die aus einem Photovoltaikmodul oder aus mehreren nebeneinander liegenden Photovoltaikmodulen gebildet wird, wobei das System (4) eine Emissionsquelle (41) für elektromagnetische Strahlungen aufweist, die dazu ausgestaltet ist, elektromagnetische Strahlungen zu emittieren, wobei das System (4) **dadurch gekennzeichnet ist, dass** es umfasst:
- Mittel (42) zum Bewegen der Emissionsquelle (41),
- eine Steuereinheit (UC), die dazu ausgestaltet ist, die Emissionsquelle (41) zu steuern, um die elektromagnetischen Strahlungen während einer bestimmten Expositionsdauer (T) mit einer gegebenen Bestrahlungsstärke (E) zu mindestens einem Teil der zu behandelnden Oberfläche (S) zu emittieren,
- wobei die Steuereinheit (UC) dazu ausgestaltet ist, die Mittel (42) zum Bewegen zu steuern, um die Emissionsquelle gegenüber der zu behandelnden Oberfläche zu verlagern, bis die gesamte Photovoltaikoberfläche überstrichen ist.

2. System nach Anspruch 1 **dadurch gekennzeichnet, dass** es Mittel zum Bestimmen eines Opazitätsgrads (DO) der Photovoltaikanlage an dem mindestens einen Teil der zu behandelnden Oberfläche umfasst.

3. System nach Anspruch 2, **dadurch gekennzeichnet, dass** die Mittel zum Bestimmen der Opazität umfassen:
- Emissionsmittel zur Emission eines Lichtstrahls zu dem mindestens einen Teil der zu behandelnden Oberfläche und Empfangsmittel zum Empfangen eines Lichtflusses, der von dem mindestens einen Teil der zu behandelnden Oberfläche reflektiert wird,
- ein Modul zur Berechnung des Opazitätsgrads anhand der von den Empfangsmitteln empfangenen Daten, das von der Steuereinheit (UC) ausgeführt wird.

4. System nach einem der Ansprüche 1 bis 3, **dadurch gekennzeichnet, dass** es Kühlmittel (43) zur Kühlung des Moduls und zur Regelung der Temperatur des Moduls auf einen bestimmten Wert bei der Exposition des mindestens einen Teils der zu behandelnden Oberfläche (S) gegenüber den elektromagnetischen Strahlungen umfasst.

5. System nach einem der Ansprüche 1 bis 4, **dadurch gekennzeichnet, dass** es Mittel zur Ermittlung der Abmessungen der zu behandelnden Oberfläche der Photovoltaikanlage umfasst.

6. System nach einem der Ansprüche 1 bis 5, **dadurch gekennzeichnet, dass** die Steuereinheit (UC) dazu ausgestaltet ist, eine Behandlungssequenz der zu behandelnden Oberfläche (S) durchzuführen, welche die folgenden Schritte umfasst:
a. Ermitteln des Opazitätsgrads (DO) der Photovoltaikanlage an einem ersten Teil der zu behandelnden Oberfläche;
b. Ermitteln der Bestrahlungsstärke und der Expositionsdauer, die auf den ersten Teil der zu behandelnden Oberfläche anzuwenden sind, unter Berücksichtigung des ermittelten Opazitätsgrads;
c. Steuern der Emissionsquelle (41), um den ersten Teil der Oberfläche zu bestrahlen;
d. Steuern der Mittel (42) zum Bewegen der Emissionsquelle (41), um sie gegenüber einem zweiten Teil der zu behandelnden Oberfläche zu positionieren, der von dem ersten Teil verschieden ist;
e. Ausführen der Schritte a) bis d), die auf den zweiten Teil der zu behandelnden Oberfläche angewandt werden.

7. System nach einem der Ansprüche 1 bis 5, **dadurch gekennzeichnet, dass** die Steuereinheit (UC) dazu ausgestaltet ist, eine Behandlungssequenz der zu behandelnden Oberfläche (S) durchzuführen, welche die folgenden Schritte umfasst:
a. Überstreichen der Oberfläche des Photovoltaikmoduls durch Verlagern der Emissionsquelle (41) mit einer Sollgeschwindigkeit;
b. Ermitteln des Opazitätsgrads (DO) des Moduls an jedem Teil der zu behandelnden Oberfläche;
c. Ermitteln der Bestrahlungsstärke und der Expositionsdauer, die auf jeden Teil der zu behandelnden Oberfläche anzuwenden sind, unter Berücksichtigung des ermittelten Opazitätsgrads;
d. Steuern der Emissionsquelle (41), um jeden Teil der zu behandelnden Oberfläche zu bestrahlen;
e. solange der ermittelte Opazitätsgrad konstant ist, Halten der Verlagerungsgeschwindigkeit der Emissionsquelle auf der Sollgeschwindigkeit;
f. wenn die Änderung des Opazitätsgrads einen Schwellenwert überschreitet, Ermitteln einer neuen Bestrahlungsstärke und einer neuen Expositionsdauer, die anzuwenden sind, und Ermitteln einer neuen Sollgeschwindigkeit, die auf die Emissionsquelle (41) anzuwenden ist.

8. System nach einem der Ansprüche 1 bis 7, **dadurch gekennzeichnet, dass** die Mittel zum Bewegen mindestens eine Schiene (420) umfassen, die an einem Rand der Photovoltaikanlage befestigt ist, und dass das System einen die Emissionsquelle (41) tragenden Arm (421) umfasst, der geeignet ist, sich entlang der Schiene verschieben zu lassen.

9. System nach einem der Ansprüche 1 bis 8, **dadurch gekennzeichnet, dass** es Mittel zur Reinigung der zu behandelnden Oberfläche (S) umfasst.

10. System nach einem der Ansprüche 1 bis 9, **dadurch gekennzeichnet, dass** die Bestrahlungsstärke zwischen 1 und 100 kW/m2 gewählt ist.

11. System nach Anspruch 10, **dadurch gekennzeichnet, dass** die Bestrahlungsstärke zwischen 1 kW/m2 und 10 kW/m2 gewählt ist.

12. System nach einem der Ansprüche 1 bis 11, **dadurch gekennzeichnet, dass** die Expositionsdauer zwischen 1 s und 30 Minuten beträgt.

13. System nach einem der Ansprüche 1 bis 12, **dadurch gekennzeichnet, dass** die Temperatur der Anlage auf einen Wert zwischen 100 °C und 250 °C geregelt ist.

## Claims

1. System (4) for treating a surface (S) to be treated of a photovoltaic installation formed from one photovoltaic module or from a plurality of juxtaposed photovoltaic modules, said system (4) comprising an emission source (41) for emitting electromagnetic radiation, said emission source being configured to emit electromagnetic radiation, said system (4) being **characterized in that** it comprises:
- means (42) for moving said emission source (41),
- a control unit (UC) configured to control said emission source (41) with a view to emitting said electromagnetic radiation for a determined exposure time (T) with a given irradiance (E) towards at least one portion of the surface (S) to be treated,
- the control unit (UC) being configured to control the moving means (42) so as to move said emission source with respect to said surface to be treated until the entire photovoltaic surface has been scanned.

2. System according to Claim 1, **characterized in that** it comprises means for determining a degree of opacity (DO) of the photovoltaic installation in said at least one portion of the surface to be treated.

3. System according to Claim 2, **characterized in that** the means for determining opacity comprise:
- means for emitting a light beam towards said at least one portion of the surface to be treated and means for receiving a light flux reflected by said at least one portion of the surface to be treated,
- a module, executed by said control unit (UC), for computing a degree of opacity on the basis of data received from the receiving means.

4. System according to one of Claims 1 to 3, **characterized in that** it comprises means (43) for cooling the module and for regulating the temperature of the module to a determined value during the exposure of said at least one portion of the surface (S) to be treated to said electromagnetic radiation.

5. System according to one of Claims 1 to 4, **characterized in that** it comprises means for determining dimensions of the surface to be treated of the photovoltaic installation.

6. System according to one of Claims 1 to 5, **characterized in that** the control unit (UC) is configured to execute a sequence of treatment of said surface (S) to be treated, comprising said following steps:
a. determining the degree of opacity (DO) of the photovoltaic installation in a first portion of the surface to be treated;
b. determining the irradiance and the exposure time to be applied to said first portion of the surface to be treated given the determined degree of opacity;
c. controlling the emission source (41) to irradiate said first portion of the surface;
d. controlling the means (42) for moving the emission source (41) to place the latter facing a second portion of the surface to be treated, said second portion being distinct from the first portion;
e. executing steps a) to d), applied to the second portion of the surface to be treated.

7. System according to one of Claims 1 to 5, **characterized in that** the control unit (UC) is configured to execute a sequence of treatment of said surface (S) to be treated, comprising said following steps:
a. scanning the surface of the photovoltaic module by moving the emission source (41) at a set speed;
b. determining the degree of opacity (DO) of the module in each portion of the surface to be treated;
c. determining the irradiance and the exposure time to be applied to each portion of the surface to be treated given the determined degree of opacity;
d. controlling the emission source (41) to irradiate each portion of the surface to be treated;
e. provided that the determined degree of opacity remains constant, keeping the speed of movement of the emission source at the set speed;
f. when the variation in the degree of opacity exceeds a threshold value, determining a new irradiance and a new exposure time to be applied, and determining a new set speed to be applied to the emission source (41).

8. System according to one of Claims 1 to 7, **characterized in that** the moving means comprise at least one rail (420) fastened to an edge of the photovoltaic installation and **in that** the system comprises an arm (421) supporting said emission source (41), said arm being configured to slide along said rail.

9. System according to one of Claims 1 to 8, **characterized in that** it comprises means for cleaning the surface (S) to be treated.

10. System according to one of Claims 1 to 9, **characterized in that** the irradiance is comprised between 1 and 100 kW/m2.

11. System according to Claim 10, **characterized in that** the irradiance is comprised between 1 kW/m2 and 10 kW/m2.

12. System according to one of Claims 1 to 11, **characterized in that** the exposure time is comprised between 1 s and 30 minutes.

13. System according to one of Claims 1 to 12, **characterized in that** the temperature of the installation is regulated to a value comprised between 100°C and 250°C.
